# EUROPÄISCHE PATENTANMELDUNG

(11) **EP 0 845 678 A2**
(43) Veröffentlichungstag der Anmeldung: **03.06.1998**
(21) Anmeldenummer: 97440120.0
(22) Anmeldetag: 28.11.1997
(51) Int. Cl.: G01R 19/00

(54) **Schaltanordung zur potentialgetrennten Spannungs- und/oder Strommessung**

(30) Priorität: 28.11.1996 DE 19649304
(71) Anmelder: ALCATEL ALSTHOM COMPAGNIE GENERALE D'ELECTRICITE, 75008 Paris (FR)
(72) Erfinder: Mohr, Werner, 71384 Weinstadt (DE)
(74) Vertreter: Schätzle, Albin, Dipl.-Phys.

(57) **Zusammenfassung**

Eine Schaltungsanordnung zur potentialgetrennten Spannungsund/oder Strommessung an einer Übertragungsleitung ist dadurch gekennzeichnet, daß in einem Querzweig zwischen dem Hinleiter (+) und dem Rückleiter (-) eine Reihenschaltung aus einem Transformator (T), einem ersten optisch ansteuerbaren, getakteten Schaltelement (OS1) und einem ersten Ohm'schen Widerstand (R1) geschaltet ist, und/oder daß in dem Hinleiter (+) oder dem Rückleiter (-) ein zweiter Ohm'scher Widerstand (R2) und parallel dazu eine Reihenschaltung aus einem Transformator (T) und einem zweiten optisch ansteuerbaren, getakteten Schaltelement (OS2) geschaltet ist. Damit können mit einfachen Mitteln und nur wenigen aktiven Bauelementen, insbesondere ohne ADC und ohne Stromversorgungen auf dem Potentialniveau der Übertragungsleitung die gemessenen Spannungs- und Stromwerte linear zu den Spannungen und Strömen auf der Übertragungsleitung abgegriffen werden.

## Beschreibung

Die Erfindung betrifft eine Schaltungsanordnung zur potentialgetrennten Spannungs- und/oder Strommessung an einer Übertragungsleitung mit einem Hinleiter und einem Rückleiter zur Fernspeisung von elektrischen Geräten.

Schaltungsanordnungen zum potentialfreien Erfassen von binären elektrischen Signalen unterschiedlicher Impulshöhe an einer Übertragungsleitung sind beispielsweise bekannt aus der EP 0 398 456 B1 oder aus dem Firmenprospekt der Firma Hewlett Packard mit dem Titel "High-Linearity Analog Optocouplers", 1993, Seiten 1 bis 16.

Bei ferngespeisten Geräten ist es üblich, daß sowohl die Fernspeisespannung als auch der Fernspeisestrom in der Endstelle gemessen werden können. Dies geschah früher ohne größeren Aufwand mit analogen Zeigerinstrumenten, die jeweils auf dem Fernspeisepotential lagen.

Durch die Einführung von Bedienterminals müssen heutzutage aber die beiden Meßwerte digital verarbeitet werden können. Dies bringt Schwierigkeiten bei der Potentialtrennung mit sich, weil die Potentiale der Spannungen auf den Übertragungsleitungen bis zu 2 kV über dem Massepotential liegen können, wobei Spannungswerte zwischen dem Hinleiter und dem Rückleiter im Bereich von 0V bis ungefähr 300V und Stromwerte im Bereich von OA bis etwa 70mA auftreten.

Eine Möglichkeit der potentialgetrennten Messung besteht in der Verwendung eines auf das Potential der Übertragungsleitung hochgelegten Analog-Digital-Wandlers (ADC), dessen Meßsignale mit Hilfe einer Optokoppler-Schnittstelle auf einem Potential in der Nähe des Massepotentials abgegriffen werden können. Dazu ist jedoch eine eigene, auf das Potential der Übertragungsleitung hochgelegte Stromversorgung erforderlich. Der Fernspeisestrom aus der Übertragungsleitung selbst kann nämlich nicht herangezogen werden, weil im Unterbrechungsfall dort kein Strom fließt und parallel nur ein sehr geringer Strom verbraucht werden darf. Ein weiteres Problem liegt darin, daß eine halbwegs lineare, temperaturunabhängige Messung mit Optokopplern nur mit aufwendigen Kompensationsschaltungen realisiert werden kann. Außerdem ergibt sich bei der Verwendung von aktiven Bauelementen wie etwa Transistoren, die notwendigerweise Bestandteil einer ADC-Schaltung sind, auf hochgelegtem Potentialniveau das Problem des sogenannten "latching", das letztlich bei schon geringer Überoder Unterschreitung der Versorgungsspannungen zu einer thermischen Vernichtung der Bauteile führen kann.

Aus der CH 676 393 A5 ist eine Schaltungsanordnung zur Umwandlung einer analogen Meßspannung in ein potentialgetrenntes, digitales Signal bekannt, bei der die gemessene Spannung über ein optoelektronisches Kopplungselement bestehend aus einer lichtemittierenden Diode (LED) und einem Phototransistor vom Potential der Übertragungsleitung in die Nähe des Erdpotentials ausgekoppelt wird. Die Spannungsmessung selbst erfolgt über einen Kondensator und einen Schaltkreis, der den Lade- und Entladevorgang des Kondensators steuert. Ein solcher Kondensator ist aber notwendigerweise recht voluminös. Zu dem folgt seine Entladungskurve einer Exponentialfunktion, was die Genauigkeit der Messung beeinträchtigt.

Aus der oben bereits zitierten EP 0 398 456 B1 ist eine Schaltungsanordnung zum potentialfreien Erfassen von binären elektrischen Signalen unterschiedlicher Impulshöhe bekannt, die einen Optokoppler aufweist, der in Reihe mit einer elektronischen Schaltungseinheit an den Hin- und Rückleitern der Schaltungsanordnung liegt. Diese Schaltungsanordnung kann zwar ohne Taktimpulse betrieben werden, hat jedoch wiederum den Nachteil, daß sie zur Messung von Analogsignalen wegen der hochgradigen Nichtlinearität des Optokopplers nicht geeignet ist. Außerdem ist wiederum eine potentialmäßig hochgelegte Konstantstromversorgung für den Optokoppler mit dem oben angesprochenen "latching"-Problem erforderlich.

Im eingangs zitierten Firmenprospekt von Hewlett Packard schließlich sind auch Schaltungsanordnungen mit Paaren von Optokopplern beschrieben, wobei die eigentlichen analogen Meßwerte in der Nähe des Massepotentials durch Vergleiche der von beiden Optokopplern abgegriffenen Signalen gewonnen werden, da ja die einzelnen Optokoppler selbst nur nicht_ analoge Signale liefern. Damit ergeben sich aber wiederum neue Probleme aufgrund der unterschiedlichen Alterung der beiden Optokoppler.

Aufgabe der vorliegenden Erfindung ist es demgegenüber, eine Schaltungsanordnung der eingangs genannten Art mit möglichst einfachen Mitteln dahingehend zu verbessern, daß möglichst wenige aktive Bauelemente, insbesondere keine Analog-Digital-Wandler und möglichst auch keine Stromversorgungen auf dem Potentialniveau der Übertragungsleitung erforderlich sind, und daß die gemessenen Spannungs- und Stromwerte in möglichst linearer Weise mit Spannungen und Strömen auf der Übertragungsleitung zusammenhängen.

Erfindungsgemäß wird diese Aufgabe hinsichtlich der Spannungsmessung auf ebenso einfache wie wirkungsvolle Art und Weise dadurch gelöst, daß in einem Querzweig zwischen dem Hinleiter und dem Rückleiter eine Reihenschaltung aus einem Transformator, einem ersten optisch ansteuerbaren, getakteten Schaltelement und einem ersten Ohm'schen Widerstand geschaltet ist.

Hinsichtlich der Strommessung wird die Erfindungsaufgabe dadurch gelöst, daß in dem Hinleiter oder dem Rückleiter ein zweiter Ohm'scher Widerstand und parallel zum zweiten Ohm'schen Widerstand eine Reihenschaltung aus einem Transformator und einem zweiten optisch ansteuerbaren, getakteten Schaltelement geschaltet ist.

Die erfindungsgemäßen Schaltanordnungen lösen die oben genannten Probleme über ein "Zerhacken" der Spannungen durch die entsprechenden optisch ansteuerbaren, getakteten Schaltelemente. Die Taktfrequenz aus einem auf Erdpotential liegenden Taktgenerator, der optisch an die Hochspannungsseite angekoppelt ist, wird in der Regel in der Größenordnung von 1 kHz liegen. Auf der Sekundärseite des Übertragers entsteht auf diese Weise eine zum jeweiligen Meßsignal proportionale Wechselspannung, die potentialgetrennt, beispielsweise auf dem Niveau des Erdpotentials abgegriffen werden kann. Dazu ist es lediglich erforderlich, daß der als Übertrager eingesetzte Transformator eine entsprechende Isolation zwischen Primär- und Sekundärseite aufweist.

Ein Analog-Digital-Wandler ist bei den erfindungsgemäßen Schaltanordnungen nicht erforderlich. Ebenso kann auf eine Stromversorgung, die auf das Potential der Übertragungsleitung hochgelegt werden muß, verzichtet werden. Durch die Minimierung der aktiven Bauelemente auf der Hochspannungsseite wird daher u.a. auch die Gefahr eines "latching" entscheidend reduziert. Schließlich ist die Spannungsmessung mit einer geringeren Last als beim Stand der Technik möglich, weil anstelle eines Netzwerks ein einfacher Ohm'scher Widerstand eingesetzt wird.

Besonders bevorzugt ist eine Ausführungsform der erfindungsgemäßen Schaltanordnung, bei der gleichzeitig eine potentialgetrennte Spannungsmessung und eine potentialgetrennte Strommessung erfolgen kann.

Insbesondere ist eine Ausführungsform dieser kombinierten Schaltungsanordnung bevorzugt, bei der für die Spannungsmessung und für die Strommessung derselbe Transformator vorgesehen ist. Auf diese Weise kann einer der beiden teuren, hochspannungsisolierten Übertrager eingespart werden.

Um ein Gleichspannungssignal für die gewünschten Meßgrößen abgreifen zu können, ist bei einer weiteren Ausführungsform der Erfindung an der Sekundärseite des Transformators eine Gleichrichtereinrichtung vorgesehen.

Bei einer Weiterbildung dieser Ausführungsform umfaßt die Gleichrichtereinrichtung mindestens eine Diode. Insbesondere kann sie auch im allereinfachsten Fall aus lediglich einer zwischen die beiden Sekundärausgänge des Transformators geschalteten Diode bestehen.

Besonders bevorzugt ist auch eine Weiterbildung der oben beschriebenen Ausführungsformen, bei der an der Primärseite des Transformators eine Konstantstromquelle zur Linearisierung der Gleichrichterkennlinie der Gleichrichterschaltung vorgesehen ist.

Dadurch kann ein größerer Dynamikbereich für die Messung eröffnet werden. Während vorher beispielsweise lediglich Spannungen zwischen Hin- und Rückleiter zwischen 50 V und 350 V abgegriffen werden konnten, können bei Einsatz einer Feststromquelle auf der Primärseite des Übertragers die auf der Sekundärseite abgegriffenen Spannungswerte zwischen 20 V und 350 V variieren.

Besonders bevorzugt ist auch eine Ausführungsform der kombinierten erfindungsgemäßen Schaltungsanordnung zur potentialgetrennten Spannungs- und Strommessung, bei der anstelle des parallel zum zweiten Ohm'schen Widerstand geschalteten zweiten optisch ansteuerbaren, getakteten Schaltelements ein Schalter vorgesehen ist, der in einer ersten Schaltstellung die Transformator-abgewandte Seite des ersten optisch ansteuerbaren, getakteten Schaltelements mit der Transformator-zugewandten Seite des ersten Ohm'schen Widerstandes oder in einer zweiten Schaltstellung mit der Transformator-abgewandten Seite des zweiten Ohm'schen Widerstandes verbinden kann. Auf diese Weise kann eines der beiden optisch ansteuerbaren, getakteten Schaltelemente eingespart werden.

Vorteilhaft ist eine Weiterbildung dieser Ausführungsform, bei der der Schalter die Transformator-abgewandte Seite des ersten optisch ansteuerbaren, getakteten Schaltelements in einer dritten Schaltstellung sowohl von der Transformator_zugewandten Seite des ersten Ohm'schen Widerstands als auch von der Transformator-abgewandten Seite des zweiten Ohm'schen Widerstandes trennen kann. Wenn keine Spannungs- oder Strommessung durchgeführt werden soll, kann der Schalter also die Schaltungsanordnung in eine Ruhestellung bringen, in der keine Verbindung zwischen Hin- und Rückleiter über die Schaltungsanordnung läuft, so daß insbesondere auch kein Verluststrom fließen kann.

Die optisch ansteuerbaren, getakteten Schaltelemente der erfindungsgemäßen Schaltanordnung sind bei bevorzugten Ausführungsformen durch PhotoMOS-Relais, insbesondere durch optoelektronisch getriebene MOSFET's realisiert. Die letztgenannten Bauelemente enthalten eine lichtemittierende Diode (LED), die mit einem auf Erdpotential befindlichen Taktgenerator mit einer Frequenz im Bereich von 1_kHz angesteuert wird und einen potentialmäßig hochgelegten MOS-Transistor über ein eingebautes Photoelement getaktet schaltet.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1: ein Blockschaltbild einer einfachen Ausführungsform der erfindungsgemäßen Schaltanordnung zur potentialgetrennten Spannungsmessung;
- Fig. 2: eine einfache Ausführungsform zur potentialgetrennten Strommessung;
- Fig. 3: eine Ausführungsform mit kombinierter potentialgetrennter Spannungs- und Strommessung;
- Fig. 4: eine Ausführungsform mit kombinierter potentialgetrennter Spannungs- und Strommessung mit lediglich einem optisch ansteuerbaren, getakteten Schaltelement und einem Umschalter; und
- Fig. 5: ein Schaltbild eines Ausführungsbeispiels mit kombinierter potentialgetrennter Spannungs- und Strommessung mit Feststromquelle zur Linearisierung der Gleichrichterkennlinie an der Primärseite des Übertragers.

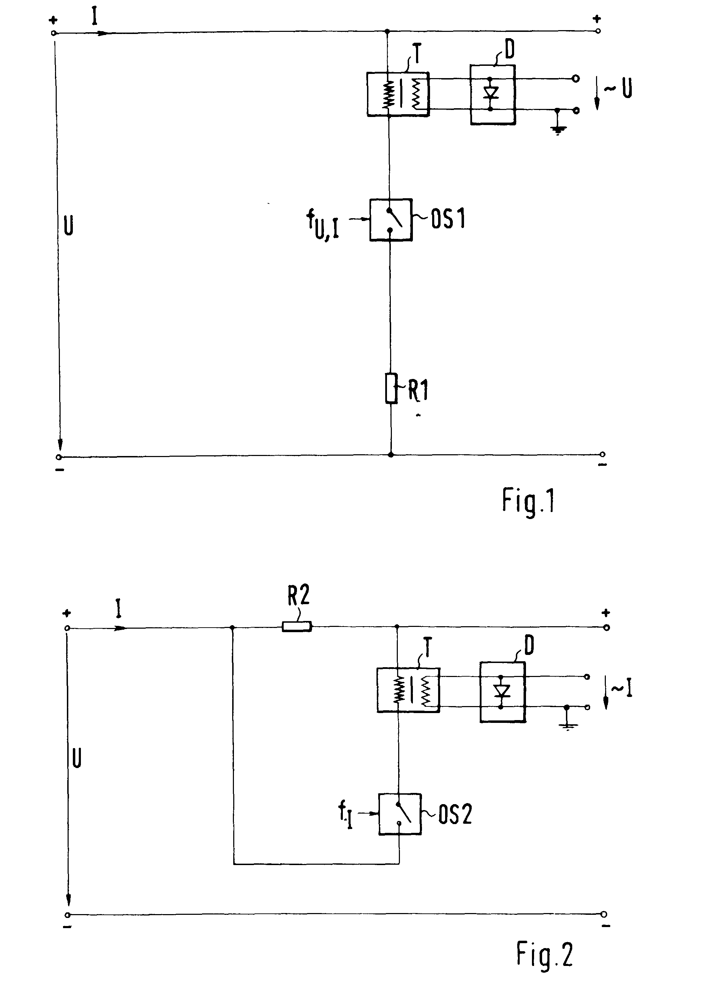

Die in Fig. 1 schematisch dargestellte Ausführungsform einer erfindungsgemäßen Schaltanordnung zur potentialgetrennten Spannungsmessung an einer Übertragungsleitung von einem mit "+" gekennzeichneten Hinleiter und einem mit "-" gekennzeichneten Rückleiter weist in einem Querzweig zwischen dem Hinleiter und dem Rückleiter eine Reihenschaltung mit einem Transformator T, einem ersten optischen ansteuerbaren, getakteten Schaltelement OS1 und einem ersten Ohm'schen Widerstand R1, der im Bereich von 200kΩ gewählt sein kann, auf.

Die über dem Widerstand R1 abfallende Spannung, die ein Maß für die Potentialdifferenz U zwischen dem Hinleiter und dem Rückleiter darstellt, wird mit dem getakteten Schaltelement OS1 zerhackt. Vorzugsweise besteht das getaktete Schaltelement OS1 aus einem PhotoMOS-Relais, insbesondere einem optoelektronisch getriebenen MOSFET. Dieses beinhaltet eine lichtemittierende Diode (LED), die beispielsweise mit einem in der Zeichnung nicht dargestellten, auf Erdpotential liegenden Taktgenerator mit einer Taktfrequenz f_{U} im Bereich von 1 kHz angesteuert wird. Die ebenfalls auf Erdpotential liegende LED sendet getaktete Lichtsignale an ein Fotoelement, das einen auf dem Potential der Übertragungsleitung liegenden MOS-Transistor mit der entsprechenden Frequenz schaltet. Dadurch entsteht an der Sekundärseite des Transformators T eine zur Meßgröße, nämlich der Potentialdifferenz U zwischen dem Hin- und dem Rückleiter proportionale Wechselspannung.

Um ein (möglicherweise auch pulsierendes) Gleichspannungssignal abgreifen zu können, ist an der Sekundärseite des Transformators T eine Gleichrichtereinrichtung D vorgesehen, die im dargestellten einfachsten Fall eine Diode umfaßt, die zwischen die beiden Sekundärausgänge des Transformators T geschaltet ist.

Bei der in Fig. 2 dargestellten, besonders einfachen Ausführungsform zur potentialgetrennten Strommessung ist in den mit "+" gekennzeichneten Hinleiter ein zweiter Ohm'scher Widerstand R2 in der Größenordnung von 100Ω eingeschaltet. Parallel zum Widerstand R2 ist eine Reihenschaltung aus einem Transformator T mit sekundärseitiger Gleichrichtereinrichtung D wie in Fig. 1 und einem zweiten optisch ansteuerbaren, getakteten Ansteuerelement OS2 geschaltet, das ebenfalls wie das für die Schaltungsanordnung in Fig. 1 beschriebene funktionieren kann und mit einer Taktfrequenz f_{I} betrieben wird. Der Fernspeisestrom I durch den Widerstand R2 wird wiederum durch "Zerhacken" der über dem Widerstand R2 abfallenden Spannung gemessen.

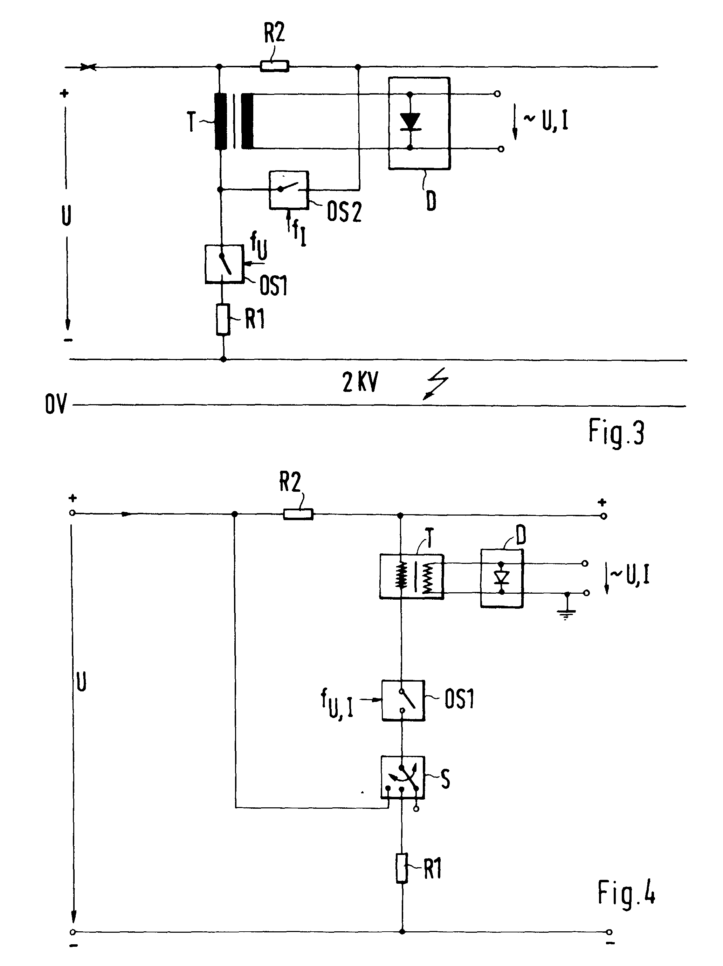

Eine kombinierte Ausführungsform der erfindungsgemäßen Schaltanordnung, die sowohl zur potentialgetrennten Spannungs- als auch Strommessung verwendet werden kann, ist in Fig. 3 dargestellt. Die verwendeten Bauteile entsprechen denen der Fign. 1 und 2, wobei jedoch derselbe Transformator T mit anschließender Gleichrichtereinrichtung D sowohl für die Spannungsmessung als auch für die Strommessung vorgesehen ist. Im gezeigten Ausführungsbeispiel ist angedeutet, daß zwischen dem Erdpotential und einem mittleren Potential der Übertragungsleitung eine Potentialdifferenz von etwa 2 kV bestehen kann.

Eine weiter verbesserte Ausführungsform der erfindungsgemäßen kombinierten Schaltanordnung für potentialgetrennte Spannungs- und Strommessung ist in Fig. 4 dargestellt. Dabei ist anstelle des parallel zum zweiten Ohm'schen Widerstand R2 in Fig. 3 geschalteten zweiten optisch ansteuerbaren, getakteten Schaltelements OS2 ein Schalter S vorgesehen, der in einer ersten Schaltstellung die Transformator-abgewandte Seite des ersten Schaltelements OS1 mit der Transformator-zugewandten Seite des Widerstands R1 oder in einer zweiten Schaltstellung mit der Transformator-abgewandten Seite des Widerstands R2 verbinden kann. In einer dritten Schaltstellung, die in Fig. 4 gezeigt ist, trennt der Schalter S die beiden Widerstände R1 und R2 von der Transformator-abgewandten Seite des Schaltelements OS1. In dieser Stellung wird weder eine Strom- noch eine Spannungsmessung vorgenommen, so daß insbesondere auch kein Querstrom zwischen Hin- und Rückleiter durch die erfindungsgemäße Schaltanordnung fließt.

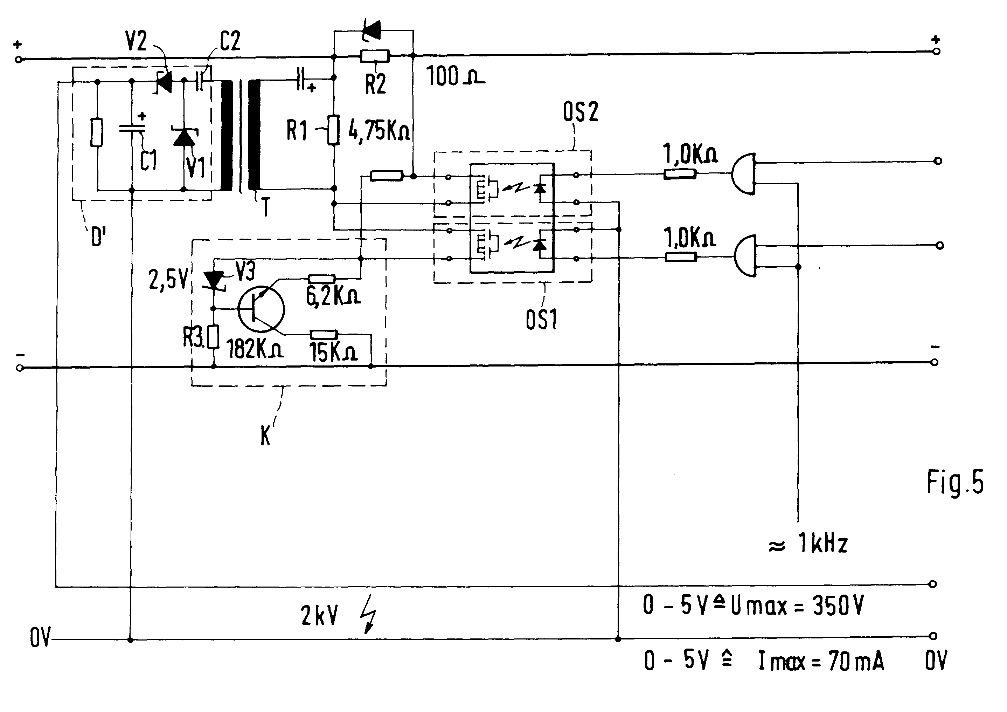

Fig. 5 schließlich zeigt ein Ausführungsbeispiel einer erfindungsgemäßen Schaltanordnung zur kombinierten potentialgetrennten Spannungs- und Strommessung, bei der an der Primärseite des Transformators T eine Konstantstromquelle K vorgesehen ist, die zur Linearisierung der Gleichrichterkennlinie der sekundärseitigen Gleichrichtereinrichtung D' dient.

In Fig. 5 sind zur Veranschaulichung auch konkrete Größen der dargestellten elektronischen Bauelemente angegeben, die aber in anderen Ausführungsbeispielen je nach Bedarf variiert werden können.

Bei der Schaltungsanordnung nach Fig. 5 wird der Fernspeisestrom durch den Ohm'schen Widerstand R2 wiederum durch "Zerhacken" des entsprechenden Spannungsabfalls gemessen. Der Ohm'sche Widerstand R1 dient gleichzeitig zur Begrenzung des Schaltstroms auf 1/50 des Nennstroms I (Welligkeit des Fernspeisestroms). Die Fernspeisespannung U wird über einen Ohm'schen Widerstand R3, der in Serie zu Widerstand R1 geschaltet ist, "zerhackt". Auch dabei wird wegen der Welligkeit des Fernspeisestroms im Mittel größenordnungsmäßig 1 mA geschaltet.

Die potentialmäßige Entkopplung der zerhackten Spannung erfolgt über den Transformator T, dem sich eine Spannungsverdopplerschaltung bestehend aus Kondensatoren C1, C2 und Schottkydioden V1, V2 sowie einem Ohm'schen Widerstand anschließt.

Da der Anzeigebereich bei Spannungsmessung größer ist als bei Strommessung (20 V bis 350 V gegenüber 30 mA bis 70 mA) wirkt sich die Schwellspannung der Gleichrichterdioden als Nichtlinearität im unteren Anzeigenbereich aus. Dem wirkt die Konstantstromquelle K um eine Referenzspannung V3 entgegen. Mit absinkender Fernspeisespannung bleibt ein Teil des "zerhackten" Stroms konstant und kompensiert so die Diodenkennlinien. So kann bis auf eine Genauigkeit von ungefähr 20 V (Verstärkerfeld) der gewünschte Meßwert erfaßt werden.

## Patentansprüche

1. Schaltungsanordnung zur potentialgetrennten Spannungsmessung an einer Übertragungsleitung mit einem Hinleiter und einem Rückleiter, zur Fernspeisung von elektrischen Geräten,
dadurch gekennzeichnet,
daß in einem Querzweig zwischen dem Hinleiter (+) und dem Rückleiter (-) eine Reihenschaltung aus einem Transformator (T), einem ersten optisch ansteuerbaren, getakteten Schaltelement (OS1 ) und einem ersten Ohm'schen Widerstand (R1 ) geschaltet ist.

2. Schaltungsanordnung zur potentialgetrennten Strommessung an einer Übertragungsleitung mit einem Hinleiter und einem Rückleiter zur Fernspeisung von elektrischen Geräten,
dadurch gekennzeichnet,
daß in dem Hinleiter (+) oder dem Rückleiter (-) ein zweiter Ohm'scher Widerstand (R2) und parallel zum zweiten Ohm'schen Widerstand (R2) eine Reihenschaltung aus einem Transformator (T) und einem zweiten optisch ansteuerbaren, getakteten Schaltelement (OS2) geschaltet ist.

3. Schaltungsanordnung nach Anspruch 1 und 2, dadurch gekennzeichnet, daß für die Spannungsmessung und für die Strommessung derselbe Transformator (T) vorgesehen ist.

4. Schaltungsanordnung nach einem der vorhergehenden Ansprüche, dadurch gekennzeichnet, daß an der Sekundärseite des Transformators (T) eine Gleichrichtereinrichtung (D) vorgesehen ist.

5. Schaltungsanordnung nach Anspruch 4, dadurch gekennzeichnet, daß die Gleichrichtereinrichtung (D) mindestens eine Diode umfaßt, insbesondere aus einer zwischen die beiden Sekundärausgänge des Transformators (T) geschalteten Diode besteht.

6. Schaltungsanordnung nach Anspruch 4 oder 5, dadurch gekennzeichnet, daß an der Primärseite des Transformators (T) eine Konstantstromquelle (K) zur Linearisierung der Gleichrichterkennlinie der Gleichrichtereinrichtung (D') an der Sekundärseite des Transformators (T) vorgesehen ist.

7. Schaltungsordnung nach einem der Ansprüche 3 bis 6 dadurch gekennzeichnet, daß anstelle des parallel zum zweiten Ohm'schen Widerstand (R2) geschalteten zweiten optisch ansteuerbaren, getakteten Schaltelements (OS2) ein Schalter (S) vorgesehen ist, der in einer ersten Schaltstellung die Transformator-abgewandte Seite des ersten optisch ansteuerbaren, getakteten Schaltelements (OS1) mit der Transformator-zugewandten Seite des ersten Ohm'schen Widerstandes (R1 ) oder in einer zweiten Schaltstellung mit der Transformator-abgewandten Seite des zweiten Ohm'schen Widerstandes (R2) verbinden kann.

8. Schaltungsanordnung nach Anspruch 7, dadurch gekennzeichnet, daß der Schalter (S) die Transformator-abgewandte Seite des ersten optisch ansteuerbaren, getakteten Schaltelements (OS1 ) in einer dritten Schaltstellung sowohl von der Transformator-zugewandten Seite des ersten Ohm'schen Widerstands (R1 ) als auch von der Transformator-abgewandten Seite des zweiten Ohm'schen Widerstandes (R2) trennen kann.

9. Schaltungsanordnung nach einem der vorhergehenden Ansprüche, dadurch gekennzeichnet, daß das erste und/oder das zweite optisch ansteuerbare, getaktete Schaltelement (OS1 bzw. OS2) jeweils ein PhotoMOS-Relais, insbesondere ein optoelektronisch getriebener MOSFET ist.
